# EUROPEAN PATENT APPLICATION

(11) **EP 4 651 375 A1**
(43) Date of publication of application: **19.11.2025**
(21) Application number: 25173573.4
(22) Date of filing: 30.04.2025
(51) Int. Cl.: H03F 3/189, H03G 3/30

(54) **MULTI-STAGE AUTOMATIC GAIN CONTROL CIRCUIT USING AT LEAST THREE GAIN-CONTROLLED AMPLIFIERS WITH GAIN HYSTERESIS AND ASSOCIATED AUTOMATIC GAIN CONTROL METHOD**

(30) Priority: 10.05.2024 US 202463645220 P; 10.04.2025 US 202519176126
(71) Applicant: MEDIATEK INC., Hsinchu City 30078 (TW)
(72) Inventor: YANG, Shih-An, 30078 Hsinchu City (TW); HORNG, Cian-Ya, 30078 Hsinchu City (TW)
(74) Representative: Haseltine Lake Kempner LLP

(57) **Abstract**

A multi-stage automatic gain control (AGC) circuit (801) includes a first gain-controlled amplifier (802), at least one second gain-controlled amplifier (804), and a third gain-controlled amplifier (806). The first gain-controlled amplifier (802) is arranged to receive an input signal of the multi-stage AGC circuit (801). The third gain-controlled amplifier (806) is arranged to generate an output signal of the multi-stage AGC circuit (801). The at least one second gain-controlled amplifier (804) is coupled between the first gain-controlled amplifier (802) and the third gain-controlled amplifier (806). Each of the first gain-controlled amplifier (802), the at least one second gain-controlled amplifier (804) and the third gain-controlled amplifier (806) has gain hysteresis which uses different gain gears for a same input power in different input power change directions.

## Description

### Field of the Invention

The present invention relates to an automatic gain control (AGC) technique, and more particularly, to a multi-stage AGC circuit using at least three gain-controlled amplifiers with gain hysteresis and an associated AGC method.

### Background of the Invention

An AGC circuit is used to maintain a constant output signal level after amplification, despite variation in an input signal level. This is achieved by providing more amplification to weak input signals and less amplification to strong input signals, thus maintaining a constant signal amplitude level at the output. For example, to cover a wide range of the input power level, a receiver chain of a wireless communication device uses a low-noise amplifier (LNA) to adjust the gain applied to an input signal for making a signal level of an output signal fall within a dynamic range that meets requirements of a following signal processing stage such as an analog-to-digital converter (ADC). However, real gain gears of the LNA may be deviated from ideal values due to certain factors, which may result in a larger LNA gain step between adjacent gain gears. The larger LNA gain step may introduce certain undesired effects.

### Summary of the Invention

This in mind, the present invention aims at providing a multi-stage AGC circuit using at least three gain-controlled amplifiers with gain hysteresis and an associated AGC method that address an issue resulting from a larger gain step between adjacent gain gears.

This is achieved by a multi-stage AGC circuit and a AGC method according to independent claims. The dependent claims pertain to corresponding further developments and improvements.

As will be seen more clearly from the detailed description following below, the claimed multi-stage AGC circuit includes a first gain-controlled amplifier, at least one second gain-controlled amplifier, and a third gain-controlled amplifier. The first gain-controlled amplifier is arranged to receive an input signal of the multi-stage AGC circuit, wherein the first gain-controlled amplifier has gain hysteresis which uses different gain gears for a same input power in different input power change directions. Each of the at least one second gain-controlled amplifier has gain hysteresis which uses different gain gears for a same input power in different input power change directions. The third gain-controlled amplifier is arranged to generate an output signal of the multi-stage AGC circuit, wherein the third gain-controlled amplifier has gain hysteresis which uses different gain gears for a same input power in different input power change directions. The at least one second gain-controlled amplifier is coupled between the first gain-controlled amplifier and the third gain-controlled amplifier.

The claimed AGC method includes: receiving and processing a first input signal by a first gain-controlled amplifier; processing an amplifier output of the first gain-controlled amplifier through at least one second gain-controlled amplifier, wherein each of the at least one second gain-controlled amplifier has gain hysteresis which uses different gain gears for a same input power in different input power change directions; and receiving and processing a second input signal derived from an amplifier output of the at least one second gain-controlled amplifier by a third gain-controlled amplifier, wherein the third gain-controlled amplifier has gain hysteresis which uses different gain gears for a same input power in different input power change directions.

### Brief Description of the Drawings

In the following, the invention is further illustrated by way of example, taking reference to the accompanying drawings. Thereof
FIG. 1 is a diagram illustrating an LNA used in a receiver chain according to an embodiment of the present invention,
FIG. 2 is a diagram illustrating characteristics of the LNA shown in FIG. 1 that operates under an ideal condition,
FIG. 3 is a diagram illustrating characteristics of the LNA shown in FIG. 1 that operates under a real condition,
FIG. 4 is a diagram illustrating an AGC circuit with gain hysteresis according to an embodiment of the present invention,
FIG. 5 is a diagram illustrating characteristics of the AGC circuit shown in FIG. 4 that operates under an ideal condition,
FIG. 6 is a diagram illustrating characteristics of the AGC circuit shown in FIG. 4 that operates under a real condition (particularly, low-to-high input power level scenario),
FIG. 7 is a diagram illustrating characteristics of the AGC circuit shown in FIG. 4 that operates under another real condition (particularly, high-to-low input power level scenario),
FIG. 8 is a diagram illustrating an analog front-end of a receiver that uses a first proposed multi-stage AGC circuit according to an embodiment of the present invention,
FIG. 9 is a diagram illustrating characteristics of the multi-stage AGC circuit shown in FIG. 8 that operates under an ideal condition,
FIG. 10 is a diagram illustrating characteristics of the multi-stage AGC circuit shown in FIG. 8 that operates under a real condition (particularly, low-to-high input power level scenario),
FIG. 11 is a diagram illustrating characteristics of the multi-stage AGC circuit shown in FIG. 8 that operates under another real condition (particularly, high-to-low input power level scenario),
FIG. 12 is a diagram illustrating an analog front-end of a receiver that uses a second proposed multi-stage AGC circuit according to an embodiment of the present invention, and
FIG. 13 is a diagram illustrating an analog front-end of a receiver that uses a third proposed multi-stage AGC circuit according to an embodiment of the present invention.

### Detailed Description

Certain terms are used throughout the following description and claims, which refer to particular components. As one skilled in the art will appreciate, electronic equipment manufacturers may refer to a component by different names. This document does not intend to distinguish between components that differ in name but not in function. In the following description and in the claims, the terms "include" and "comprise" are used in an open-ended fashion, and thus should be interpreted to mean "include, but not limited to ...". Also, the term "couple" is intended to mean either an indirect or direct electrical connection. Accordingly, if one device is coupled to another device, that connection may be through a direct electrical connection, or through an indirect electrical connection via other devices and connections.

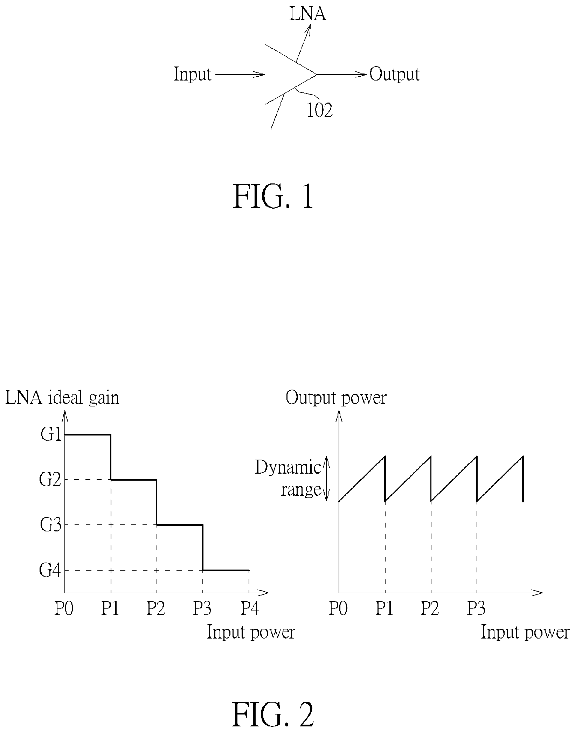

FIG. 1 is a diagram illustrating an LNA 102 used in a receiver chain according to an embodiment of the present invention. FIG. 2 is a diagram illustrating characteristics of the LNA 102 operating under an ideal condition. The LNA 102 is designed to have a plurality of gain gears such as G1, G2, G3, G4 (G1 > G2 > G3 > G4). When the input power level is within a power range [P0, P1 (P1 > P0)], the LNA 102 is controlled to use the gain gear G1. When the input power level is within a power range [P1, P2 (P2 > P1)], the LNA 102 is controlled to use the gain gear G2. When the input power level is within a power range [P2, P3 (P3 > P2)], the LNA 102 is controlled to use the gain gear G3. When the input power level is within a power range [P3, P4 (P4 > P3)], the LNA 102 is controlled to use the gain gear G4. By switching between different gain gears according to the input power, the output power of the LNA 102 is constrained within a dynamic range.

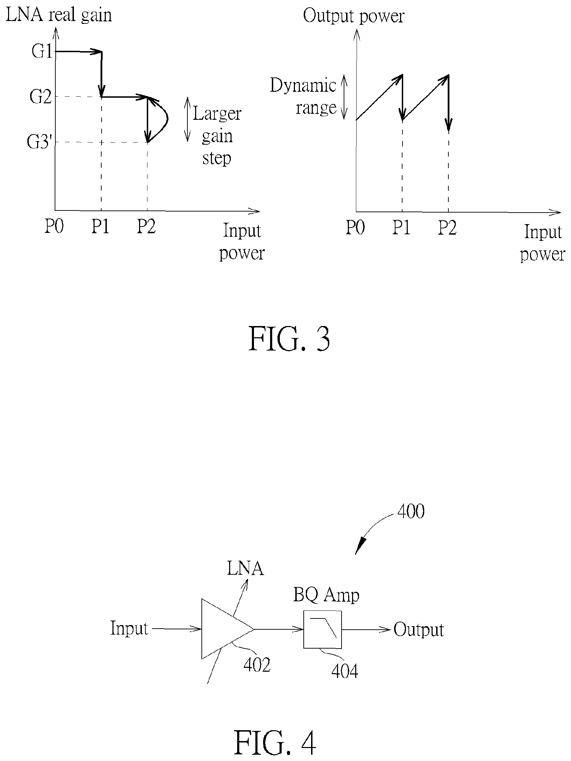

However, the real gain gears of the LNA 102 may be deviated from ideal values due to certain factors, which may result in a larger LNA gain step between adjacent gain gears. FIG. 3 is a diagram illustrating characteristics of the LNA 102 operating under a real condition. The real gain gear G3' shown in FIG. 3 is lower than the ideal gain gear G3 shown in FIG. 2, which results in a larger gain step between the gain gears G2 and G3'. When the input power level decreases to reach P2, the LNA 102 is controlled to use the gain gear G3'. The larger gain step makes the output power level drops below a lower bound of the dynamic range. When detecting that the output power level is lower that the lower bound of the dynamic range, a control logic of the LNA 102 judges that the gain gear should be increased from the current gain gear G3' to a higher gain gear (i.e., G2). Hence, the larger gain step introduces a ping-pong effect and makes the LNA gain gear unstable. That is, in certain power level, no gain gear can let the output power level fall within the dynamic range due to the larger gain step.

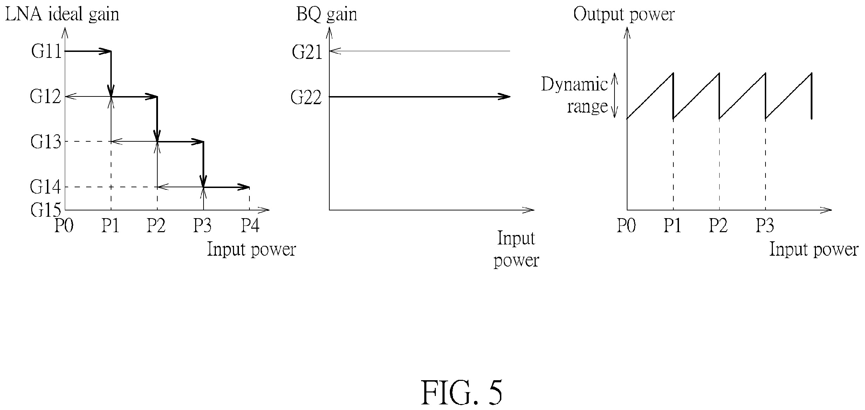

To address the gain gear's ping-pong issue, gain-controlled amplifiers with gain hysteresis are used in an AGC circuit. FIG. 4 is a diagram illustrating an AGC circuit with gain hysteresis according to an embodiment of the present invention. FIG. 5 is a diagram illustrating characteristics of the AGC circuit 400 operating under an ideal condition. The AGC circuit 400 includes an LNA 402 and a biquadratic amplifier (labeled by "BQ Amp") 404. The biquadratic amplifier 404 is designed to have gain hysteresis which uses different gain gears for a same input power in different input power change directions. Since the total gain of the AGC circuit 400 is jointly controlled by the LNA 402 and the biquadratic amplifier 404, the LNA 402 is also designed to have gain hysteresis which uses different gain gears for a same input power in different input power change directions.

The LNA 402 is designed to have a plurality of gain gears such as G11, G12, G13, G14, G15 (G11 > G12 > G13 > G14 > G15). Consider a case where the AGC circuit 400 operates in a low-to-high input power level scenario (i.e., a scenario where a current input power level is higher than a previous input power level). When the input power level is within a power range [P0, P1 (P1 > P0)], the LNA 402 is controlled to use the gain gear G11. When the input power level is within a power range [P1, P2 (P2 > P1)], the LNA 402 is controlled to use the gain gear G12. When the input power level is within a power range [P2, P3 (P3 > P2)], the LNA 402 is controlled to use the gain gear G13. When the input power level is within a power range [P3, P4 (P4 > P3)], the LNA 402 is controlled to use the gain gear G14. Specifically, when the input power level increases to reach P1, the LNA 402 is controlled to switch from the current gain gear G11 to the next gain gear G12; when the input power level increases to reach P2, the LNA 402 is controlled to switch from the current gain gear G12 to the next gain gear G13; and when the input power level increases to reach P3, the LNA 402 is controlled to switch from the current gain gear G13 to the next gain gear G14.

Consider another case where the AGC circuit 400 operates in a high-to-low input power level scenario (i.e., a scenario where a current input power level is lower than a previous input power level). When the input power level is within a power range [P3, P4 (P4 > P3)], the LNA 402 is controlled to use the gain gear G15. When the input power level is within a power range [P2, P3 (P3 > P2)], the LNA 402 is controlled to use the gain gear G14. When the input power level is within a power range [P1, P2 (P2 > P1)], the LNA 402 is controlled to use the gain gear G13. When the input power level is within a power range [P0, P1 (P0 > P1)], the LNA 402 is controlled to use the gain gear G11. Specifically, when the input power level decreases to reach P3, the LNA 402 is controlled to switch from the current gain gear G15 to the next gain gear G14; when the input power level decreases to reach P2, the LNA 402 is controlled to switch from the current gain gear G14 to the next gain gear G13; and when the input power level decreases to reach P1, the LNA 402 is controlled to switch from the current gain gear G13 to the next gain gear G12.

The biquadratic amplifier 404 is designed to have two gain gears such as G21 and G22 (G21 > G22). In a case where the AGC circuit 400 operates in a low-to-high input power level scenario (i.e., a scenario where a current input power level is higher than a previous input power level), the biquadratic amplifier 404 is controlled to use the low gain gear G22. In another case where the AGC circuit 400 operates in a high-to-low input power level scenario (i.e., a scenario where a current input power level is lower than a previous input power level), the biquadratic amplifier 404 is controlled to use the high gain gear G21.

As shown in FIG. 5, the difference between G11 and G12 is equal to the difference between G21 and G22, the difference between G12 and G13 is equal to the difference between G21 and G22, and so on. By controlling the LNA 402 to switch between different gain gears according to the input power and the input power level scenario and controlling the biquadratic amplifier 404 to select one of the high gain gear and the low gain gear according to the input power level scenario, the output power of the AGC circuit 400 (particularly, output power of biquadratic amplifier 404) is constrained within a dynamic range.

However, the real gain gears of the LNA 402 may be deviated from ideal values due to certain factors, which may result in a larger LNA gain step between adjacent gain gears. Due to inherent characteristics of the biquadratic amplifier 404, the high gain gear G21 and the low gain gear G22 can be set accurately. Hence, the high gain gear G21 of the biquadratic amplifier 404 can be used to compensate for an excessive output power drop caused by the larger LNA gain step in the low-to-high input power level scenario, and the low gain gear G22 of the biquadratic amplifier 404 can be used to compensate for an excessive output power boost caused by the larger LNA gain step in the high-to-low input power level scenario.

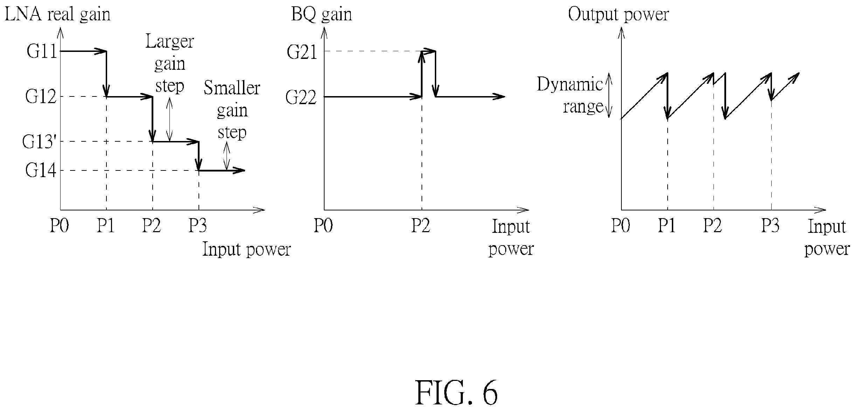

FIG. 6 is a diagram illustrating characteristics of the AGC circuit 400 operating under a real condition (particularly, low-to-high input power level scenario). In this example, the real gain gear G13' shown in FIG. 6 is lower than the ideal gain gear G13 shown in FIG. 5, which results in a larger gain step between the gain gears G12 and G13' and a smaller gain step between the gain gears G14 and G13'. When the input power level increases to reach P2, the LNA 402 is controlled to use the gain gear G13'. The larger gain step makes the output power level drops below a lower bound of the dynamic range. At this moment, a control logic of the biquadratic amplifier 404 judges that the gain gear should be increased. Hence, the biquadratic amplifier 404 is controlled to switch from the low gain gear G22 to the high gain gear G21. In this way, the combination of the gain gear G13' and the high gain gear G21 keeps the output power level within the dynamic range.

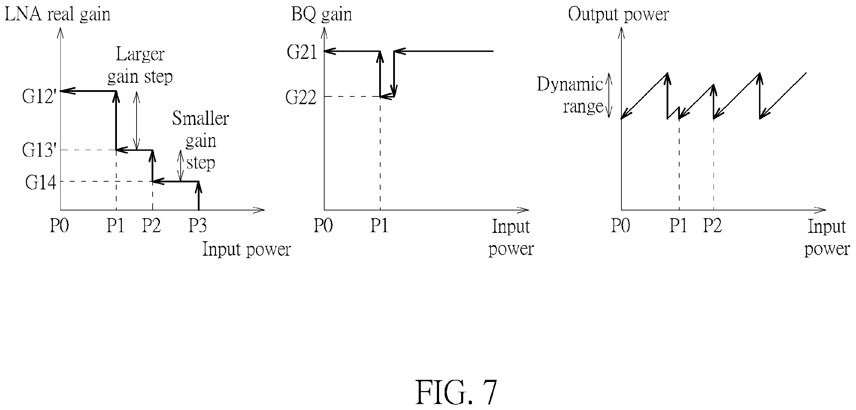

FIG. 7 is a diagram illustrating characteristics of the AGC circuit 400 operating under another real condition (particularly, high-to-low input power level scenario). In this example, the real gain gear G12' shown in FIG. 7 is higher than the ideal gain gear G12 shown in FIG. 5 and the real gain gear G13' shown in FIG. 7 is lower than the ideal gain gear G13 shown in FIG. 5, which results in a larger gain step between the gain gears G12' and G13' and a smaller gain step between the gain gears G14 and G13'. When the input power level decreases to reach P1, the LNA 402 is controlled to use the gain gear G12'. The larger gain step makes the output power level shoots over an upper bound of the dynamic range. At this moment, a control logic of the biquadratic amplifier 404 judges that the gain gear should be decreased. Hence, the biquadratic amplifier 404 is controlled to switch from the high gain gear G21 to the low gain gear G22. In this way, the combination of the gain gear G12' and the low gain gear G22 keeps the output power level within the dynamic range.

The use of the biquadratic amplifier 404 with gain hysteresis can avoid the ping-pong issue of the LNA 402. However, when there is a larger gain step error possessed by the LNA 402, the biquadratic amplifier 404 (which is the final stage of the AGC circuit 400) is required to have a higher high-gain gear (which is higher than the high gain gear G22) and a lower low-gain gear (which is lower than the low gain gear G21) for output power compensation. When an amplifier has a lower gain, weaker signal amplification is provided by the amplifier, which results in a lower signal-to-noise ratio (SNR). When the biquadratic amplifier 404 is designed to use a lower low-gain gear (which is lower than the low gain gear G21) for output power compensation, an output of the biquadratic amplifier 404 used in an analog front-end of the receiver chain causes degradation of the radio-frequency (RF) SNR performance. To overcome the large gain step error and enhance the RF SNR performance, the present invention proposes inserting one or more intermediate gain-controlled amplifiers with gain hysteresis between a first stage of an AGC circuit (e.g. an LNA with gain hysteresis) and a final stage of the AGC circuit (e.g., a biquadratic amplifier with gain hysteresis) to share a burden of the output power compensation, which allows the final stage of the AGC circuit (e.g., a biquadratic amplifier with gain hysteresis) not to use a higher high-gain gear and a lower low-gain gear for output power compensation.

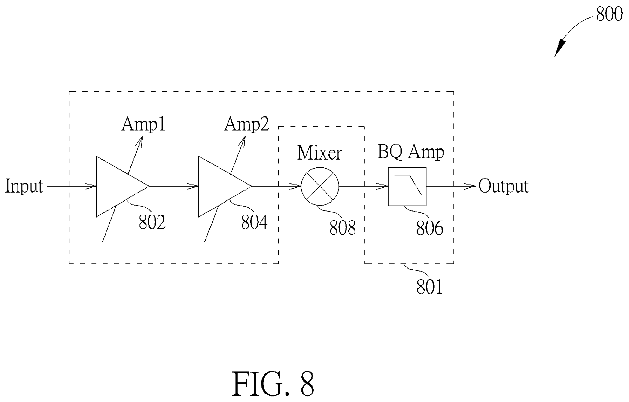

FIG. 8 is a diagram illustrating an analog front-end of a receiver that uses a first proposed multi-stage AGC circuit according to an embodiment of the present invention. The analog front-end 800 includes a multi-stage AGC circuit 801 and a mixer 808, where the multi-stage AGC circuit 801 includes a plurality of gain-controlled amplifiers 802, 804, 806. The gain-controlled amplifier (labeled by "Amp1") 802 is arranged to receive an input signal of the multi-stage AGC circuit 801, and has gain hysteresis which uses different gain gears for a same input power in different input power change directions. The gain-controlled amplifier (labeled by "Amp2") 804 is arranged to receive an amplifier output of the preceding gain-controlled amplifier 802, and generate and output an amplifier output to the following mixer 808. The gain-controlled amplifier 804 has gain hysteresis which uses different gain gears for a same input power in different input power change directions. The gain-controlled amplifier (labeled by "BQ Amp") 806 is arranged to receive a mixer output from the preceding mixer 808, and generate an output signal of the multi-stage AGC circuit 801. The gain-controlled amplifier 806 has gain hysteresis which uses different gain gears for a same input power in different input power change directions. Specifically, the gain-controlled amplifier 804 is coupled between the gain-controlled amplifiers 802 and 806, and is coupled to the gain-controlled amplifier 806 through the mixer 808. In this embodiment, the multi-stage AGC circuit 801 is employed by the analog front-end 800 of the receiver. However, this is for illustrative purposes only, and is not meant to be a limitation of the present invention. In practice, any analog circuit using the multi-stage AGC circuit 801 (which has one intermediate-stage gain-controlled amplifier with gain hysteresis coupled between the first-stage gain-controlled amplifier with gain hysteresis and the final-stage gain-controlled amplifier with gain hysteresis) falls within the scope of the present invention. For example, in some embodiments of the present invention, the mixer 808 shown in FIG. 8 may be omitted.

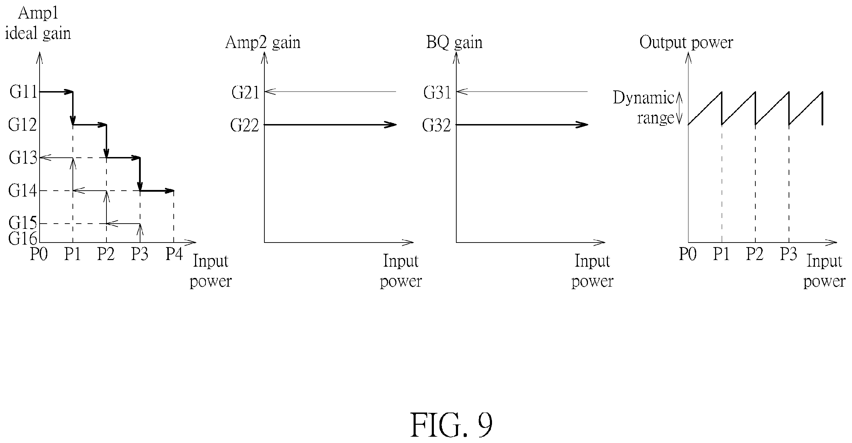

FIG. 9 is a diagram illustrating characteristics of the multi-stage AGC circuit 801 operating under an ideal condition. The gain-controlled amplifier 802 is designed to have a plurality of gain gears such as G11, G12, G13, G14, G15, G16 (G11 > G12 > G13 > G14 > G15 > G16). Consider a case where the multi-stage AGC circuit 801 operates in a low-to-high input power level scenario (i.e., a scenario where a current input power level is higher than a previous input power level). When the input power level is within a power range [P0, P1 (P1 > P0)], the gain-controlled amplifier 802 is controlled to use the gain gear G11. When the input power level is within a power range [P1, P2 (P2 > P1)], the gain-controlled amplifier 802 is controlled to use the gain gear G12. When the input power level is within a power range [P2, P3 (P3 > P2)], the gain-controlled amplifier 802 is controlled to use the gain gear G13. When the input power level is within a power range [P3, P4 (P4 > P3)], the gain-controlled amplifier 802 is controlled to use the gain gear G14. Specifically, when the input power level increases to reach P1, the gain-controlled amplifier 802 is controlled to switch from the current gain gear G11 to the next gain gear G12; when the input power level increases to reach P2, the gain-controlled amplifier 802 is controlled to switch from the current gain gear G12 to the next gain gear G13; and when the input power level increases to reach P3, the gain-controlled amplifier 802 is controlled to switch from the current gain gear G13 to the next gain gear G14.

Consider another case where the multi-stage AGC circuit 801 operates in a high-to-low input power level scenario (i.e., a scenario where a current input power level is lower than a previous input power level). When the input power level is within a power range [P3, P4 (P4 > P3)], the gain-controlled amplifier 802 is controlled to use the gain gear G16. When the input power level is within a power range [P2, P3 (P3 > P2)], the gain-controlled amplifier 802 is controlled to use the gain gear G15. When the input power level is within a power range [P1, P2 (P2 > P1)], the gain-controlled amplifier 802 is controlled to use the gain gear G14. When the input power level is within a power range [P0, P1 (P0 > P1)], the gain-controlled amplifier 802 is controlled to use the gain gear G13. Specifically, when the input power level decreases to reach P3, the gain-controlled amplifier 802 is controlled to switch from the current gain gear G16 to the next gain gear G15; when the input power level decreases to reach P2, the gain-controlled amplifier 802 is controlled to switch from the current gain gear G15 to the next gain gear G14; and when the input power level decreases to reach P1, the gain-controlled amplifier 802 is controlled to switch from the current gain gear G14 to the next gain gear G13.

The gain-controlled amplifier 804 is designed to have at least two gain gears. For better comprehension of technical features of the present invention, the following assumes that the gain-controlled amplifier 804 is designed to have two gain gears G21 and G22 (G21 > G22) only. In a case where the multi-stage AGC circuit 801 operates in a low-to-high input power level scenario (i.e., a scenario where a current input power level is higher than a previous input power level), the gain-controlled amplifier 804 is controlled to use the low gain gear G22. In another case where the multi-stage AGC circuit 801 operates in a high-to-low input power level scenario (i.e., a scenario where a current input power level is lower than a previous input power level), the gain-controlled amplifier 804 is controlled to use the high gain gear G21.

The gain-controlled amplifier 806 is designed to have at least two gain gears. For better comprehension of technical features of the present invention, the following assumes that the gain-controlled amplifier 806 is designed to have two gain gears G31 and G32 (G31 > G32) only. In this embodiment, the gain gear G31 may be the same as the gain gear G21, and the gain gear G32 may be the same as the gain gear G22. However, this is for illustrative purposes only, and is not meant to be a limitation of the present invention. In a case where the multi-stage AGC circuit 801 operates in a low-to-high input power level scenario (i.e., a scenario where a current input power level is higher than a previous input power level), the gain-controlled amplifier 806 is controlled to use the low gain gear G32. In another case where the multi-stage AGC circuit 801 operates in a high-to-low input power level scenario (i.e., a scenario where a current input power level is lower than a previous input power level), the gain-controlled amplifier 806 is controlled to use the high gain gear G31.

As shown in FIG. 9, the difference between G11 and G13 is equal to a sum of the difference between G21 and G22 and the difference between G31 and G32, the difference between G12 and G14 is equal to a sum of the difference between G21 and G22 and the difference between G31 and G32, and so on. By controlling the gain-controlled amplifier 802 to switch between different gain gears according to the input power and the input power level scenario and controlling each of the gain-controlled amplifiers 804, 806 to select one of the high gain gear and the low gain gear according to the input power level scenario, the output power of the multi-stage AGC circuit 801 (particularly, output power of gain-controlled amplifier 806) is constrained within a dynamic range.

The gain-controlled amplifier 802 has more than two gain gears to cover a wide input power range. However, the real gain gears of the gain-controlled amplifier 802 may be deviated from ideal values due to certain factors, which may result in a larger LNA gain step between adjacent gain gears. Each of the follow-up gain-controlled amplifiers 804 and 806 has two gain gears for gain hysteresis, and can be used for output power compensation. In this embodiment, the final-stage gain-controlled amplifier 806 may be implemented using a biquadratic amplifier. Due to inherent characteristics of the biquadratic amplifier, the high gain gear G31 and the low gain gear G32 can be set accurately. Compared to the final-stage gain-controlled amplifier 806 implemented using the biquadratic amplifier (which provides a gain control function as well as a filter function), the intermediate-stage gain-controlled amplifier 804 may have the high gain gear G21 and the low gain gear G22 that are less accurate. However, with the help of the accurate high gain gear G31 and low gain gear G32 possessed by the final-stage gain-controlled amplifier 806, the objective of jointly using the high gain gear G21 of the intermediate-stage gain-controlled amplifier 804 and the high gain gear G31 of the final-stage gain-controlled amplifier 806 to compensate for an excessive output power drop caused by the larger gain step of the first-stage gain-controlled amplifier 802 in the low-to-high input power level scenario can still be achieved, and the objective of jointly using the low gain gear G22 of the intermediate-stage gain-controlled amplifier 804 and the low gain gear G32 of the final-stage gain-controlled amplifier 806 to compensate for an excessive output power boost caused by the larger gain step of the first-stage gain-controlled amplifier 802 in the high-to-low input power level scenario can still be achieved.

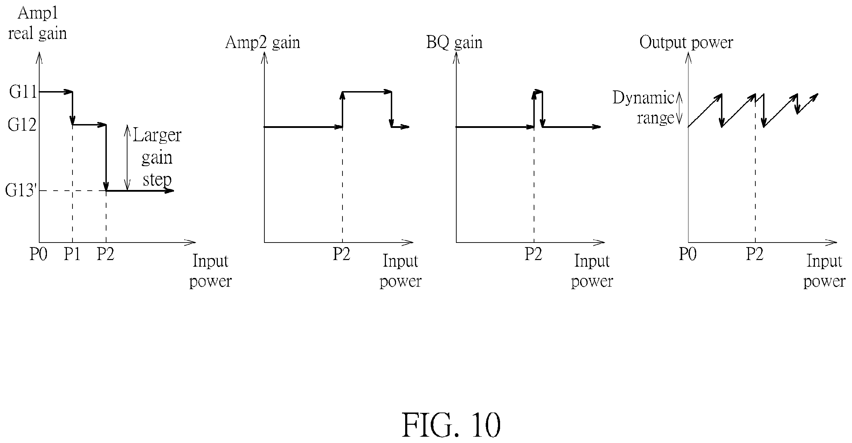

FIG. 10 is a diagram illustrating characteristics of the multi-stage AGC circuit 801 operating under a real condition (particularly, low-to-high input power level scenario). In this example, the real gain gear G13' shown in FIG. 10 is lower than the ideal gain gear G13 shown in FIG. 9, which results in a larger gain step between the gain gears G12 and G13'. When the input power level increases to reach P2, the gain-controlled amplifier 802 is controlled to use the gain gear G13'. The larger gain step makes the output power level drops below a lower bound of the dynamic range. At this moment, a control logic of the gain-controlled amplifier 804 judges that the gain gear should be increased, and a control logic of the gain-controlled amplifier 806 also judges that the gain gear should be increased. Hence, the gain-controlled amplifier 804 is controlled to switch from the low gain gear G21 to the high gain gear G22, and the gain-controlled amplifier 806 is controlled to switch from the low gain gear G31 to the high gain gear G32. In this way, the combination of the gain gear G13', the high gain gear G21 and the high gain gear G31 keeps the output power level within the dynamic range.

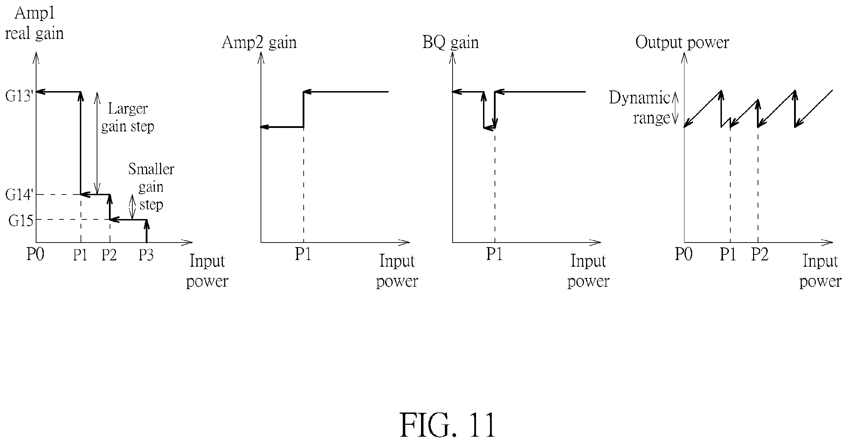

FIG. 11 is a diagram illustrating characteristics of the multi-stage AGC circuit 801 operating under another real condition (particularly, high-to-low input power level scenario). In this example, the real gain gear G14' shown in FIG. 11 is lower than the ideal gain gear G14 shown in FIG. 9 and the real gain gear G13' shown in FIG. 11 is higher than the ideal gain gear G13 shown in FIG. 9, which results in a larger gain step between the gain gears G13 and G14' and a smaller gain step between the gain gears G14' and G15. When the input power level decreases to reach P1, the gain-controlled amplifier 802 is controlled to use the gain gear G13'. The larger gain step makes the output power level shoots over an upper bound of the dynamic range. At this moment, a control logic of the gain-controlled amplifier 804 judges that the gain gear should be decreased, and a control logic of the gain-controlled amplifier 806 also judges that the gain gear should be decreased. Hence, the gain-controlled amplifier 804 is controlled to switch from the high gain gear G21 to the low gain gear G22, and the gain-controlled amplifier 806 is controlled to switch from the high gain gear G31 to the low gain gear G32. In this way, the combination of the gain gear G13', the low gain gear G22 and the low gain gear G32 keeps the output power level within the dynamic range.

As mentioned above, when an amplifier has a lower gain, weaker signal amplification is provided by the amplifier, which results in a lower SNR. Regarding the AGC circuit 400 shown in FIG. 4, it suffers degradation of the RF SNR performance due to using a final-stage gain-controlled amplifier (i.e., biquadratic amplifier 404) with a lower low-gain gear to compensate for the excessive output power shoot resulting from a larger gain step error possessed by a first-stage gain-controlled amplifier (i.e., LNA 402). To address this issue, the multi-stage AGC circuit 801 proposed by the present invention jointly uses an intermediate-stage gain-controlled amplifier (i.e., gain-controlled amplifier 804) with a higher low-gain gear and a final-stage gain-controlled amplifier (i.e., gain-controlled amplifier 806) with a higher low-gain gear to compensate for the excessive output power shoot resulting from a larger gain step error possessed by a first-stage gain-controlled amplifier (i.e., gain-controlled amplifier 802). To put it simply, the multi-stage AGC circuit 801 proposed by the present invention can avoid the ping-pong effect, and can enhance the RF SNR performance. Better SNR performance means higher throughput in a communication system.

Regarding the embodiment shown in FIG. 8, there is only a single intermediate-stage gain controlled amplifier 804 coupled between the first-stage gain-controlled amplifier 802 and the final-stage gain-controlled amplifier 806. However, this is for illustrative purposes only, and is not meant to be a limitation of the present invention. In practice, the number of intermediate-stage gain controlled amplifiers can be adjusted, depending upon actual design considerations.

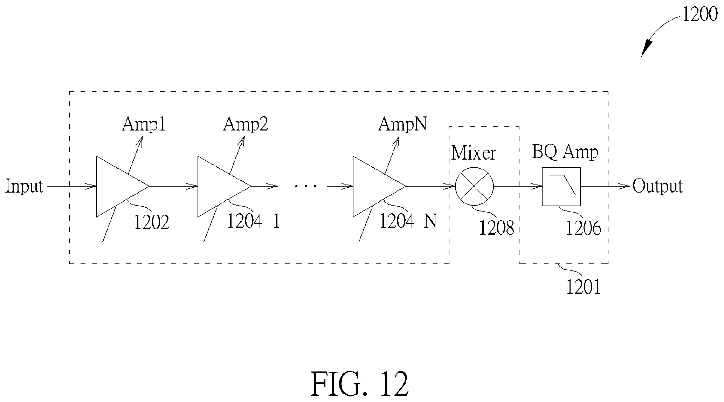

FIG. 12 is a diagram illustrating an analog front-end of a receiver that uses a second proposed multi-stage AGC circuit according to an embodiment of the present invention. The analog front-end 1200 includes a multi-stage AGC circuit 1201 and a mixer 1208, where the multi-stage AGC circuit 1201 includes a plurality of gain-controlled amplifiers 1202, 1204_1-1204_N (N ≥ 2), 1206. The gain-controlled amplifier (labeled by "Amp1") 1202 is arranged to receive an input signal of the multi-stage AGC circuit 1201, and has gain hysteresis which uses different gain gears for a same input power in different input power change directions. The gain-controlled amplifiers (labeled by "Amp2" and "AmpN") 1204_1-1204_N are connected in series, and are arranged to process an amplifier output of the preceding gain-controlled amplifier 1202 and generate and output an amplifier output to the following mixer 1208. Each of the gain-controlled amplifiers 2104_1-1204_N has gain hysteresis which uses different gain gears for a same input power in different input power change directions. The gain-controlled amplifier (labeled by "BQ Amp") 1206 is arranged to receive a mixer output from the preceding mixer 1208, and generate an output signal of the multi-stage AGC circuit 1201. The gain-controlled amplifier 1206 has gain hysteresis which uses different gain gears for a same input power in different input power change directions. In this embodiment, the multi-stage AGC circuit 1201 is employed by the analog front-end 1200 of the receiver. However, this is for illustrative purposes only, and is not meant to be a limitation of the present invention. In practice, any analog circuit using the multi-stage AGC circuit 1201 (which has multiple intermediate-stage gain-controlled amplifiers with gain hysteresis coupled between the first-stage gain-controlled amplifier with gain hysteresis and the final-stage gain-controlled amplifier with gain hysteresis) falls within the scope of the present invention. For example, in some embodiments of the present invention, the mixer 1208 shown in FIG. 12 may be omitted.

The gain-controlled amplifier 1202 has more than two gain gears to cover a wide input power range. Each of the following gain-controlled amplifiers 1204_1-1204_N and 1206 has two gain gears for gain hysteresis, and can be used for output power compensation. For example, the final-stage gain-controlled amplifier 1206 may be implemented using a biquadratic amplifier. Due to inherent characteristics of the biquadratic amplifier, the high gain gear and the low gain gear of the final-stage gain-controlled amplifier 1206 can be set accurately. Compared to the final-stage gain-controlled amplifier 1206 implemented using the biquadratic amplifier (which provides a gain control function as well as a filter function), each of the intermediate-stage gain-controlled amplifiers 1204_1-1204_N may have the high gain gear and the low gain gear that are less accurate. However, with the help of the accurate high gain gear and low gain gear possessed by the final-stage gain-controlled amplifier 1206, the objective of jointly using the high gain gears of the intermediate-stage gain-controlled amplifiers 1204_1-1204_N and the high gain gear of the final-stage gain-controlled amplifier 1206 to compensate for an excessive output power drop caused by the larger gain step of the first-stage gain-controlled amplifier 1202 in the low-to-high input power level scenario can still be achieved, and the objective of jointly using the low gain gears of the intermediate-stage gain-controlled amplifier 1204_1-1204_N and the low gain gear of the final-stage gain-controlled amplifier 1206 to compensate for an excessive output power boost caused by the larger gain step of the first-stage gain-controlled amplifier 1202 in the high-to-low input power level scenario can still be achieved.

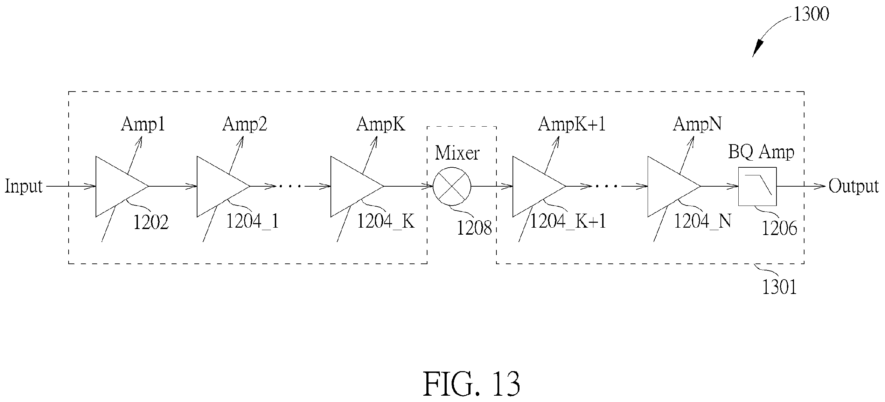

Compared to the multi-stage AGC circuit 801 using only a single intermediate-stage gain-controlled amplifier added between the first-stage gain-controlled amplifier and the final-stage gain-controlled amplifier, the multi-stage AGC circuit 1201 using more than one intermediate-stage gain-controlled amplifier added between the first-stage gain-controlled amplifier and the final-stage gain-controlled amplifier can provide larger gain step error tolerance. Larger gain step error tolerance means a more robust system and a lower hardware cost.
Regarding the embodiment shown in FIG. 12, all of the intermediate-stage gain controlled amplifiers 1204_1-1204_N are located before the mixer 1208. However, this is for illustrative purposes only, and is not meant to be a limitation of the present invention. In some embodiments of the present invention, the multi-stage AGC circuit 1201 may be modified to have at least one intermediate-stage gain controlled amplifier located before the mixer 1208 and at least one intermediate-stage gain controlled amplifier located after the mixer 1208. FIG. 13 is a diagram illustrating an analog front-end of a receiver that uses a third proposed multi-stage AGC circuit according to an embodiment of the present invention. The analog front-end 1300 includes a multi-stage AGC circuit 1301 and the mixer 1208. Like the multi-stage AGC circuit 1201, the multi-stage AGC circuit 1301 includes gain-controlled amplifiers 1202, 1204_1-1204_N (N ≥ 2), 1206. The difference between multi-stage AGC circuits 1201 and 1301 is that the multi-stage AGC circuit 1301 has gain-controlled amplifiers (labeled by "Amp2" and "AmpK") 1204_1-1204_K connected in series between the gain-controlled amplifier (labeled by "Amp1") 1202 and the mixer 1208, and further has gain-controlled amplifiers (labeled by "AmpK+1" and "AmpN") 1204_K+1-1204_N connected in series between the mixer 1208 and the gain-controlled amplifier (labeled by "BQ Amp") 1206. Hence, the series-connected gain-controlled amplifiers 1204_1-1204_K are arranged to generate a first amplifier output to the mixer 1208; the series-connected gain-controlled amplifiers 1204_K+1-1204_N are arranged to receive a mixer output of the mixer 1208, and generate a second amplifier output according to the mixer output of the mixer 1208; and the gain-controlled amplifier 1206 is arranged to receive the second amplifier output, and generate the output signal of the multi-stage AGC circuit 1301 according to the second amplifier output. Since a person skilled in the art can readily understand functions and operations of the multi-stage AGC circuit 1301 after reading above paragraphs directed to the multi-stage AGC circuit 1201, further description is omitted here for brevity.

## Claims

1. A multi-stage automatic gain control, hereinafter referred to as AGC, circuit (801, 1201, 1301) **characterized by**:
a first gain-controlled amplifier (802, 1202), arranged to receive an input signal of the multi-stage AGC circuit (801, 1201, 1301), wherein the first gain-controlled amplifier (802, 1202) has gain hysteresis which uses different gain gears for a same input power in different input power change directions;
at least one second gain-controlled amplifier (804, 1204_1-1204_N), wherein each of the at least one second gain-controlled amplifier (804, 1204_1-1204_N) has gain hysteresis which uses different gain gears for a same input power in different input power change directions; and
a third gain-controlled amplifier (806, 1206), arranged to generate an output signal of the multi-stage AGC circuit (801, 1201, 1301), wherein the third gain-controlled amplifier (806, 1206) has gain hysteresis which uses different gain gears for a same input power in different input power change directions;
wherein the at least one second gain-controlled amplifier (804, 1204_1-1204_N) is coupled between the first gain-controlled amplifier (802, 1202) and the third gain-controlled amplifier (806, 1206).

2. The multi-stage AGC circuit (801) of claim 1, **characterized in that** the at least one second gain-controlled amplifier (804) comprises only a single second gain-controlled amplifier.

3. The multi-stage AGC circuit (1201, 1301) of claim 1, **characterized in that** the at least one second gain-controlled amplifier (1204_1-1204_N) comprises multiple second gain-controlled amplifiers connected in series.

4. The multi-stage AGC circuit (801, 1201, 1301) of claim 1, **characterized in that** each of the at least one second gain-controlled amplifier (804, 1204_1-1204_N) has a first gain gear and a second gain gear lower than the first gain gear; the third gain-controlled amplifier (806, 1206) has a third gain gear and a fourth gain gear lower than the third gain gear; and in a low-to-high input power level scenario, each of the at least one second gain-controlled amplifier (804, 1204_1-1204_N) operates in the second gain gear, and the third gain-controlled amplifier (806, 1206) operates in the fourth gain gear.

5. The multi-stage AGC circuit (801, 1201, 1301) of claim 1, **characterized in that** each of the at least one second gain-controlled amplifier (804, 1204_1-1204_N) has a first gain gear and a second gain gear lower than the first gain gear; the third gain-controlled amplifier (806, 1206) has a third gain gear and a fourth gain gear lower than the third gain gear; and in a high-to-low input power level scenario, each of the at least one second gain-controlled amplifier (804, 1204_1-1204_N) operates in the first gain gear, and the third gain-controlled amplifier (806, 1206) operates in the third gain gear.

6. The multi-stage AGC circuit (801, 1201, 1301) of claim 4 or 5, **characterized in that** each of the at least one second gain-controlled amplifier (804, 1204_1-1204_N) and the third gain-controlled amplifier (806, 1206) has two gain gears only.

7. The multi-stage AGC circuit (801, 1201, 1301) of claim 1, **characterized in that** the at least one second gain-controlled amplifier (804, 1204_1-1204_N) is arranged to generate an amplifier output to a mixer (808, 1208), and the third gain-controlled amplifier (806, 1206) is arranged to receive a mixer output of the mixer (808, 1208), and generate the output signal of the multi-stage AGC circuit (801, 1201) according to the mixer output of the mixer (808, 1208); or
wherein the at least one second gain-controlled amplifier (1204_1-1204_N) comprises multiple second gain-controlled amplifiers (1204_1-1204_K, 1204_K+1-1204_N) arranged to generate a first amplifier output to a mixer (1208), receive a mixer output of the mixer (1208), and generate a second amplifier output according to the mixer output of the mixer (1208); and the third gain-controlled amplifier (1206) is arranged to receive the second amplifier output, and generate the output signal of the multi-stage AGC circuit (1301) according to the second amplifier output.

8. The multi-stage AGC circuit (801, 1201, 1301) of claim 1 or 7, **characterized in that** the third gain-controlled amplifier (806, 1206) is a biquadratic amplifier.

9. An automatic gain control, hereinafter referred to as AGC, method **characterized by**:
receiving and processing a first input signal by a first gain-controlled amplifier (802, 1202);
processing an amplifier output of the first gain-controlled amplifier (802, 1202) through at least one second gain-controlled amplifier (804, 1204_1-1204_N), wherein each of the at least one second gain-controlled amplifier (804, 1204_1-1204_N) has gain hysteresis which uses different gain gears for a same input power in different input power change directions; and
receiving and processing a second input signal derived from an amplifier output of the at least one second gain-controlled amplifier (804, 1204_1-1204_N) by a third gain-controlled amplifier (806, 1206), wherein the third gain-controlled amplifier (806, 1206) has gain hysteresis which uses different gain gears for a same input power in different input power change directions.

10. The AGC method of claim 9, **characterized in that** the at least one second gain-controlled amplifier (804) comprises only a single second gain-controlled amplifier.

11. The AGC method of claim 9, **characterized in that** the at least one second gain-controlled amplifier (1204_1-1204_N) comprises multiple second gain-controlled amplifiers connected in series.

12. The AGC method of claim 9, **characterized in that** each of the at least one second gain-controlled amplifier (804, 1204_1-1204_N) has a first gain gear and a second gain gear lower than the first gain gear; the third gain-controlled amplifier (806, 1206) has a third gain gear and a fourth gain gear lower than the third gain gear; processing the amplifier output of the first gain-controlled amplifier (802, 1202) through the at least one second gain-controlled amplifier (804, 1204_1-1204_N) comprises:
in a low-to-high input power level scenario, controlling each of the at least one second gain-controlled amplifier (804, 1204_1-1204_N) to operate in the second gain gear; and receiving and processing the second input signal derived from the amplifier output of the at least one second gain-controlled amplifier (804, 1204_1-1204_N) by the third gain-controlled amplifier (806, 1206) comprises:
in the low-to-high input power level scenario, controlling the third gain-controlled amplifier (806, 1206) to operate in the fourth gain gear.

13. The AGC method of claim 9, **characterized in that** each of the at least one second gain-controlled amplifier (804, 1204_1-1204_N) has a first gain gear and a second gain gear lower than the first gain gear; the third gain-controlled amplifier (806, 1206) has a third gain gear and a fourth gain gear lower than the third gain gear; processing the amplifier output of the first gain-controlled amplifier (802, 1202) through the at least one second gain-controlled amplifier (804, 1204_1-1204_N) comprises:
in a high-to-low input power level scenario, controlling each of the at least one second gain-controlled amplifier (804, 1204_1-1204_N) to operate in the first gain gear; and receiving and processing the second input signal derived from the amplifier output of the at least one second gain-controlled amplifier (804, 1204_1-1204_N) by the third gain-controlled amplifier (806, 1206) comprises:
in the high-to-low input power level scenario, controlling the third gain-controlled amplifier (806, 1206) to operate in the third gain gear.

14. The AGC method of claim 12 or 13, **characterized in that** each of the at least one second gain-controlled amplifier (804, 1204_1-1204_N) and the third gain-controlled amplifier (806, 1206) has two gain gears only.

15. The AGC method of claim 9, **characterized in that** the at least one second gain-controlled amplifier (804, 1204_1-1204_N) is arranged to generate an amplifier output to a mixer (808, 1208), and the third gain-controlled amplifier (806, 1206) is arranged to receive a mixer output of the mixer (808, 1208) as the second input signal; or
wherein the at least one second gain-controlled amplifier (1204_1-1204_N) comprises multiple second gain-controlled amplifiers (1204_1-1204_K, 1204_K+1-1204_N) arranged to generate a first amplifier output to a mixer (1208), receive a mixer output of the mixer (1208), and generate a second amplifier output according to the mixer output of the mixer (1208); and the third gain-controlled amplifier (1206) is arranged to receive the second amplifier output as the second input signal.
